# EUROPEAN PATENT APPLICATION

(11) **EP 4 428 928 A1**
(43) Date of publication of application: **11.09.2024**
(21) Application number: 24305307.1
(22) Date of filing: 27.02.2024
(51) Int. Cl.: H01L 29/778, H01L 23/29, H01L 23/31, H01L 29/10, H01L 29/40, H01L 29/20

(54) **HEMT DEVICE HAVING A REDUCED ON-RESISTANCE AND MANUFACTURING PROCESS THEREOF**

(30) Priority: 10.03.2023 IT 202300004566
(71) Applicant: STMicroelectronics International N.V., 1228 Plan-les-Ouates, Geneva (CH)
(72) Inventor: TRINGALI, Cristina, 96011 AUGUSTA (SR) (IT); CONSTANT, Aurore, 37100 TOURS (FR); CASTAGNA, Maria Eloisa, 95123 CATANIA (IT); IUCOLANO, Ferdinando, 95030 GRAVINA DI CATANIA (CT) (IT)
(74) Representative: Studio Torta S.p.A.

(57) **Abstract**

A HEMT transistor (50) is formed on a semiconductor body (52) having a semiconductive heterostructure (54, 56). A gate region (57) of a semiconductor material, is arranged on the semiconductor body (52) and has lateral sides. Sealing regions (61) of non-conductive material extend on the lateral sides of the gate region (57); and a passivation layer (65) of non-conductive material has surface portions (65A) extending on the semiconductor body (52), on both sides of the gate region (57) and at a distance therefrom. Spacer regions (62) extend laterally and in contact with the sealing regions (61). The passivation layer (65) furthermore has raised portions (65B) extending on the spacer regions (62), laterally and at a distance from the sealing regions (61). The sealing regions (61) and the passivation layer (65) have different characteristic, such as are of different material or have different thicknesses.

## Description

### Technical Field

The present invention relates to a High Electron Mobility Transistor (HEMT) having a reduced on-resistance and to the manufacturing process thereof.

### Background

As known, the HEMT devices, also known as heterostructure field effect transistors (HFET), are finding wide diffusion, thanks to the possibility of operating at high voltages, their high breakdown voltage and ahigh density ad mobility.

In an HEMT device, a semiconductive heterostructure (based generally on AlGaN/GaN layers) allows a so-called 2-dimensional electron gas (2DEG) to be spontaneously generated in the device, thereby forming a channel path for electrical charges. The spontaneous channel may be modulated by applying suitable voltages at a gate region, over the channel path.

AlGaN/GaN HEMTs are normally depletion-mode. However, for practical applications, enhancement mode (normally off) devices are preferred to obtain safe operation and to drive circuits simplification.

Several approaches to achieve normally-off HEMTs based on AlGaN/GaN layers have been proposed, including forming recessed gate transistors, carrying out particular manufacturing steps such as incorporating fluorine plasma under the gate, or forming the gate region of p-GaN. The last solution is for example used in products available on the market and considered hereinbelow.

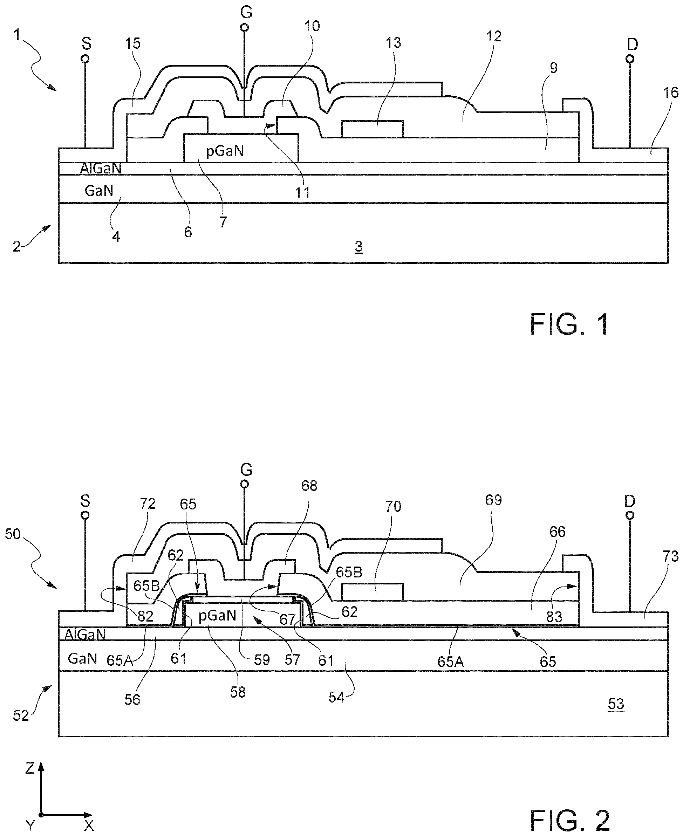

For example, Figure 1 shows an HEMT device 1, formed on a semiconductor body 2, here comprising a substrate layer 3, a first layer 4 and a second layer 6 (hereinafter also referred to as channel layer 4 and barrier layer 6).

Substrate layer 3 may comprise a silicon substrate and gallium nitride (GaN) buffer layer, not shown separately in Figure 1.

Channel layer 4 is of a first semiconductor material, such as for example a first semiconductive alloy of elements of the groups III and V of the periodic table; for example, the channel layer 4 may be of gallium nitride (GaN).

Barrier layer 6 overlies, and is in direct contact with, the channel layer 4, and is of a second semiconductor material, such as, for example, a second semiconductive alloy, different from the first semiconductive alloy, of elements of the groups III-V of the periodic table. For example, barrier layer 6 may be of aluminium gallium nitride (AlGaN) .

Channel layer 4 and barrier layer 6 are for example of N-type.

A gate region 7, of conductive material, extends on barrier layer 6. Gate region 7 is formed, for example, by a third semiconductor material, such as for example a third semiconductive alloy of elements of the groups III and V of the periodic table; in particular, gate region 7 is formed here by gallium nitride of P conductivity type (pGaN).

A first insulating region 9, for example of silicon oxide, extends on barrier layer 6, on lateral surfaces and on an upper surface of the gate region 7.

An opening 11 extends throughout first insulating region 9, on top of gate region 7, and a gate metal region 10, for example of TiN/AlCu/TiN, extends in the opening 11, in direct electrical contact with gate region 7, and partially on the first insulating region 9.

A second insulating region 12, for example of silicon oxide, extends on the first insulating region 9 and on the gate metal region 10.

A field plate 13, of conductive material, may extend on the first insulating region 9, laterally to the gate metal region 10, and below the second insulating region 12. Field plate 13 is possibly formed from a same metal layer as the gate metal region 10.

A source metal region 15, for example of Ti/AlCu/TiN extends on and laterally to the second insulating region 12 and is in direct electrical contact with the barrier layer 6. In HEMT device 1, source metal region 15 has a portion extending over gate metal region 10 and over field plate region 13 and has a shielding function.

A drain metal region 16, for example of Ti/AlCu/TiN, extends on and laterally to the second insulating region 12 (on an opposite side of the gate region 7 with respect to source metal region 15), on and in direct electrical contact with barrier layer 6.

In this type of HEMT transistors, etching of the layers over semiconductor body 2 is critic and may affect the barrier layer 6. In fact, such etchings may damage barrier layer 6 and cause an increase of the sheet resistance thereof, thereby causing an increase of the on-resistance (Ron) of the HEMT device 1.

To avoid this criticality, it has already been suggested to change parameters (thickness, percentage of Al) of barrier layer 6; however, this solution has the disadvantage of reducing also the pinch off voltage Vpo and thus the threshold voltage of the device; in addition it reduces also the gate current Igon. The selection of the parameters thus implies a trade-off between Ron, Vpo/Vth and Igo.

Another known solution to the above problem resides in arranging a protective layer of ammonium hydroxide resistant material (such as of Al₂O₃ or AlN) on the lateral sides and (partially) on the upper side of the gate region 7, for, *i.a.,* stopping lateral leakage therefrom.

However also this solution is disadvantageous, since the dielectric parameters (e.g., thickness and material) of the added protective layer affect in opposite way the gate leakage and the sheet resistance; therefore, optimal values of the sheet resistance may imply a worsening in the gate leakage.

Other known transistors provide for an additional dielectric layer near the gate regions stacks but require a more complex manufacturing process with a consequent increase of costs of the final device.

Still other known solutions are disclosed in US 2020/335617 A1 and US 2013/193485 A1. In US 2020/335617 A1, an HEMT device comprising a gate electrode arranged on the barrier layer is presented; a lower dielectric film (including nitrogen-containing compound) is formed over the gate electrode and partially over the barrier layer (extending from and close to drain-side sidewall of the gate electrode); the resulting 2DEG has a higher sheet resistance as compared to normal 2DEG at the interface of the channel layer and the barrier layer; furthermore, an upper dielectric film (including oxygen-containing compound) is formed over the lower dielectric film and the barrier layer (i.e., extending on the remaining exposed portion of it); the resulting 2DEG has a lower sheet resistance as compared to normal 2DEG; however, the lower dielectric film and the upper dielectric film are in contact at the gate electrode. US 2013/193485 A1 discloses the generic structure of an HEMT device, comprising, among the others, a protective film (insulating) - covering partially a two-dimensional electron gas suppressing layer and an electron supply layer - and an insulating film, formed over the protective film; the total thickness of the protective film and the insulating film may be selected according to desired breakdown voltage and electric field concentration requirements; however, the protective film and the insulating film are in contact at the two-dimensional electron gas suppressing layer.

Thus, an aim of the invention is to overcome the drawbacks and limitations of the prior art.

### Summary

According to the present invention, there are provided an HEMT device and the manufacturing process thereof, as defined in the attached claims.

### Brief Description of the Drawings

For the understanding of the present invention, embodiments thereof are now described, purely as a non-limitative examples, with reference to the enclosed drawings, wherein:
- Figure 1 is a cross-section of a known HEMT device;
- Figure 2 is a cross-section of an HEMT device according to an embodiment;
- Figure 3A-3H are cross-sections of a semiconductor wafer in subsequent manufacturing steps of the HEMT device of Figure 2;
- Figure 4A-4C are cross-sections of a semiconductor wafer in subsequent manufacturing steps of a different embodiment of the present HEMT device;
- Figure 5 is a cross-section of an HEMT device according to another embodiment; and
- Figures 6A and 6B are cross-sections of a semiconductor wafer in subsequent manufacturing steps the HEMT device of Figure 5.

### Description of Embodiments

The following description refers to the arrangement shown in the drawings; consequently, expressions such as "above", "below", "upper", "lower", "top", "bottom", "right", "left" and the like are relative to the attached Figures and should not be interpreted in a limiting way.

Figure 2 shows a HEMT device 50, comprising a semiconductor body 52, here formed by a substrate layer 53, a channel layer 54 and barrier layer 56.

Substrate layer 53 may comprise a silicon substrate and gallium nitride (GaN) buffer layer, not shown separately in Figure 2.

Channel layer 54 is of a first semiconductor material, such as a first semiconductive alloy of elements of the groups III and V of the periodic table; for example, channel layer 54 may be of gallium nitride (GaN).

Barrier layer 56 overlies, and is in direct contact with, channel layer 54, and is of a second semiconductor material, such as a second semiconductive alloy, different from the first semiconductive alloy, of elements of the groups III-V of the periodic table. For example, barrier layer 56 may be of aluminium gallium nitride (AlGaN).

Channel layer 54 and barrier layer 56 are for example of N-type.

A gate region 57, of conductive material, extends on and in contact with barrier layer 56. In a manner not shown, gate region 57 is strip-shaped and extends along a first horizontal axis Y of a cartesian reference system XYZ.

In Figure 2, gate region 57 comprises a channel modulating region 58, here of pGaN (gallium nitride of P conductivity type), and an interlayer region 59.

As known to the person skilled in the art, channel modulating region 58 operates to modulate the thickness of the channel formed at the interface between the channel layer 56 and the barrier layer 56, based on the voltage applied thereto.

Interlayer region 59 operates to facilitate switching-on of channel modulating region 58 and to create a barrier to the diffusion of contaminants of upper layers, as described later on. Interlayer region 59 may be of a material such as TiN.

In the embodiment of Figure 2, interlayer region 59 has a smaller width than channel modulating region 58, along a second horizontal axis X of cartesian reference system XYZ. Interlayer region 59 is optional.

Sealing regions 61 cover lateral sides and (partially) an upper side of channel modulating region 58 as well as lateral sides of interlayer region 59 and extend along the first horizontal axis Y. Sealing regions 61 are formed by a layer a non-conductive material, for example an oxide such as Al₂O₃. As alternatives, HfO₂, AlN and AlON may be used.

Sealing regions 61 may have a thickness comprised between 2 and 10 nm, for example of 2.5 nm.

Spacer regions 62 extend laterally and contiguously to the sealing regions 61, on both sides of channel modulating region 58 and of interlayer region 59. Spacer regions 62 are of a dielectric material such as silicon oxide.

A passivation layer 65 extends on the sides of the spacer regions 62 and on the substrate 52. In detail, passivation layer 65 has two surface portions 65A (each extending on and in contact with barrier layer 56 on opposite sides of gate region 57) and two raised portions 65B extending each on a respective spacer region 62 and, partially, on a respective side of interlayer region 59.

The surface portions 65A of passivation layer 65, extending on barrier layer 56, form an access region of HEMT device 50.

Passivation layer 65 is opened on interlayer region 59 to expose most of the upper surface of the latter. Passivation layer 65 is of an insulating material, e.g., AlN.

In general, passivation layer 65 may have a thickness different from the thickness of the sealing regions 61.

In this embodiment, passivation layer 65 has a greater thickness than the layer forming the sealing regions 61. In particular, passivation layer 65 may have a thickness comprised between 2 and 10 nm, for example of 5 nm.

A first insulating layer 66, for example of silicon oxide, extends on passivation layer 65 and is opened on the interlayer region 59, thereby forming, together with passivation layer 65, a gate opening 67.

A gate metal 68, for example a multilayer of TiN/AlCu/TiN, extends in the gate opening 67, in direct electrical contact with the interlayer region 59, and partially on the first insulating layer 66.

A second insulating layer 69, for example of silicon oxide, extends on first insulating layer 66 and on gate metal 68.

First and second insulating layers 66 and 69 form an insulating structure 66, 69. Insulating structure 66, 69 has a source opening 82 and a drain opening 83, extending on different sides of gate region 57, through the entire thickness of insulating structure 66, 69, until barrier layer 56.

A source metal region 72, for example of Ti/AlCu/TiN, extends in source opening 82 and is here in direct electrical contact with barrier layer 56. In HEMT device 50, source metal region 72 has a portion extending also over the gate metal 68 and over the field plate 70 and has a shielding function.

A field plate 70 may extend on the first insulating layer 66, on a side, but at a distance of gate region 57, below the second insulating layer 69. Field plate 70 is possibly formed from a same metal layer as gate metal 68 and is electrically connected to source metal region 72.

A drain metal region 73, for example of Ti/AlCu/TiN, extends in drain opening 83 and is here in direct electrical contact with barrier layer 56. Drain metal region 73 is on an opposite side of gate region 57 with respect to source metal region 72.

HEMT device 50 of Figure 2, by having the sealing regions 61 on the sides of gate region 57 that have different properties from the surface portions 65A at the access region, forms different 2DEGs at the gate region and at the access region and, namely, a first 2DEG (hereinafter also called gate 2DEG) at the interface between the channel layer 54 and the barrier layer 56 under gate region 57 and a second 2DEG (hereinafter also called access 2DEG) at the interface between the channel layer 54 and the barrier layer 56 under the surface portions 65A of passivation layer 65.

By tailoring and optimizing the parameters/features of the sealing regions 61 and the passivation layer 65, it is thus possible to tailor and optimize the densities of gate 2DEG and of access 2DEG according to the desired properties.

In particular, with the structure of Figure 2, it is possible to have a high sheet resistance Rsh under and around gate region 57, resulting in a high threshold voltage and low electric field at the corner between channel modulating region 58 and barrier layer 56 (at gate 2DEG) and a low sheet resistance Rsh under passivation layer 65, resulting in a low on-resistance Ron (at access 2DEG).

HEMT device 50 thus allows to obtain a good trade-off between gate current, threshold voltage and on-resistance.

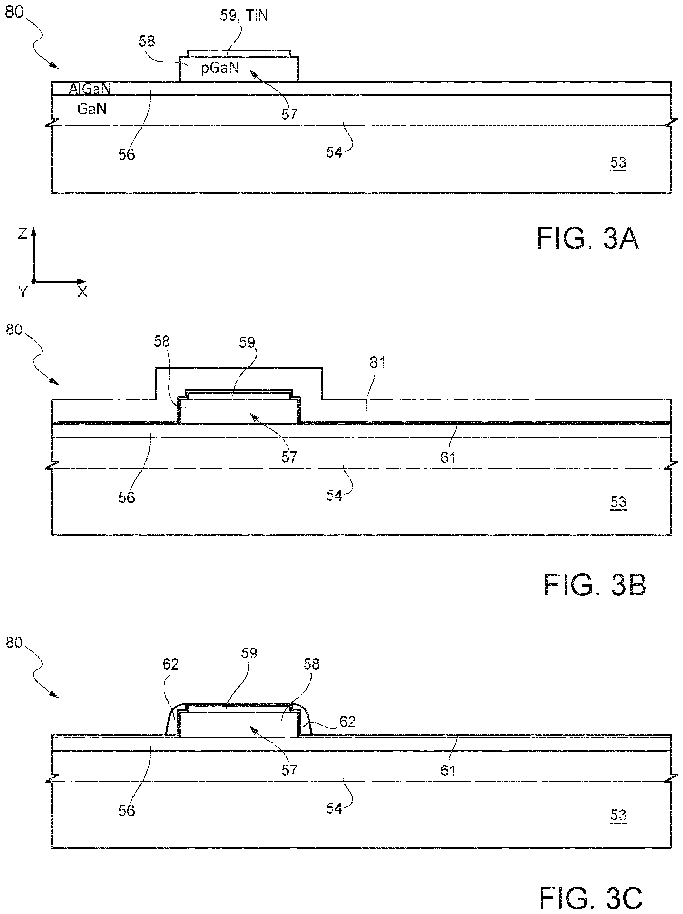

HEMT device 50 may be manufactured as shown in Figures 3A-3H, showing a wafer before dicing and using the same reference numbers as the homonymous regions in Figure 2.

Figure 3A shows a wafer 80 comprising a stack of layers including substrate layer 53, channel layer 54 and barrier layer 56. Gate region 57 has been already formed on barrier layer 56.

For example, channel modulating region 58 and interlayer region 59 may be formed by sputtering a TiN layer on a pGaN layer (not shown, grown epitaxially on barrier layer 56) and by lithographically defining the TiN layer and the pGaN layer using a single mask (also not shown) with a lateral etch to obtain the smaller width of interlayer region 59; however any other manufacturing steps are possible, for example by using two different masks.

In Figure 3B, a sealing layer 61 is formed on gate region 57 and on barrier layer 56, where exposed, and then an oxide layer 81 is formed.

For example, sealing layer 61 is thermally or plasma deposited with an ALD (Atomic Layer Deposition) technique in a H₂O or O₃ based environment at 300°C for a thickness of, e.g., 2.5 nm.

Oxide layer 81 may be, e.g., deposited by PECVD (Plasma Enhanced Chemical Vapour Deposition) in a SiO₂ SiH₄-based environment for a thickness of, e.g., 200 nm.

In Figure 3C, oxide layer 81 is anisotropically (dry) etched, without mask, to remove it from the surface of barrier layer 56 and from the top of interlayer region 59 and leaving it on the lateral surface of gate region 57, thereby forming spacer regions 62.

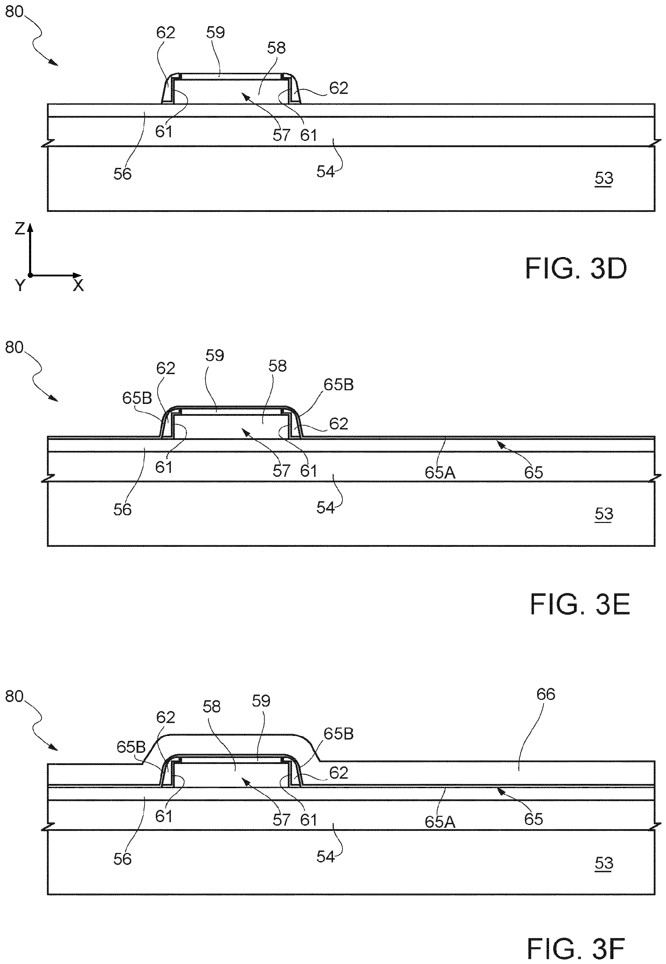

In Figure 3D, sealing layer 61 is etched on top of interlayer region 59 and over barrier layer 56, where not covered by spacer regions 62. For example, etching is a wet one, done using an etchant selective with respect to the material of barrier layer 56 of AlGaN, in particular using EKC265^{™} produced by DuPont^{™}. Thereby, a selective removal from barrier layer 56 can be obtained, without damaging the barrier layer 56 itself, and thus, in operation, without affecting access 2DEG. As a consequence, the sheet resistance Rsh is not negatively affected by this etching.

A surface portion of the sealing layer 61 also remains under the spacers 62.

In Figure 3E, passivation layer 65 is formed, e.g. of AlN and using an ALD technique at about 370°C for a thickness of, for example, 5 nm.

In Figure 3F, first insulating layer 66, for example of silicon oxide, is deposited, for example by PECVD in a SiO₂ SiH₄-based environment for a thickness of, e.g., 50 nm.

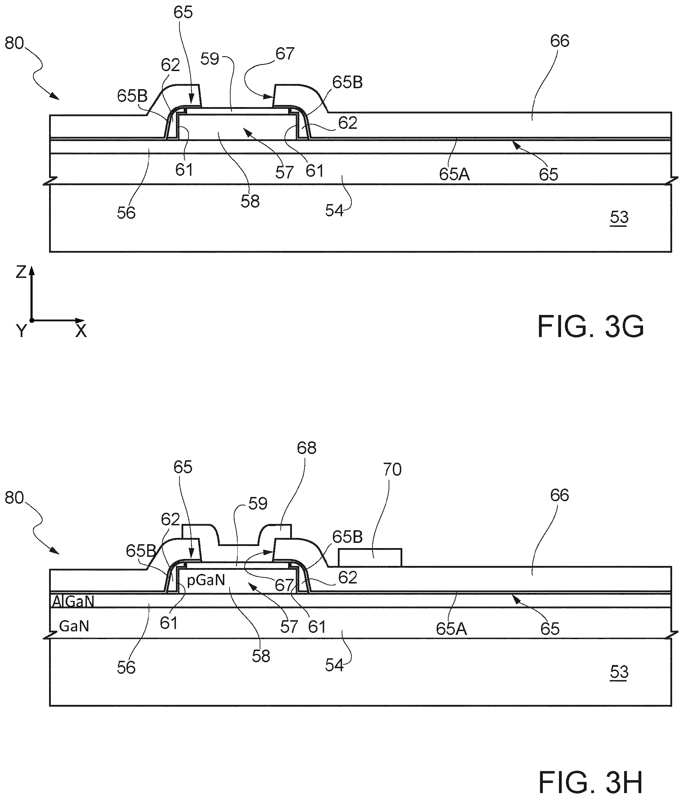

In Figure 3G, first insulation layer 66 and passivation layer 65 are etched using a mask (not shown) to form gate opening 67, thereby exposing the top surface of gate region 57. Etching of first insulation layer 66 and passivation layer 65 may be a time etch, of wet or dry etch, depending on selectivity of the used material, as known to the person skilled in the art.

In Figure 3H, a gate metal layer is deposited and defined to form gate metal 68 (in gate opening 67) and field plate 70 (laterally thereto). Gate metal layer may be a multilayer of TiN/AlCu/TiN.

Then, in a manner not shown, second insulating layer 69 is deposited and then defined together with first insulation layer 66 (using a mask not shown) to form source opening 82 and drain opening 83. Thereafter a source/drain metal layer is deposited and defined to form source metal region 72 and drain metal region 73.

Then final manufacturing steps follow, including depositing an outer passivation layer, opening contacts and dicing the wafer 80, thereby obtaining HEMT device 50 of Figure 2.

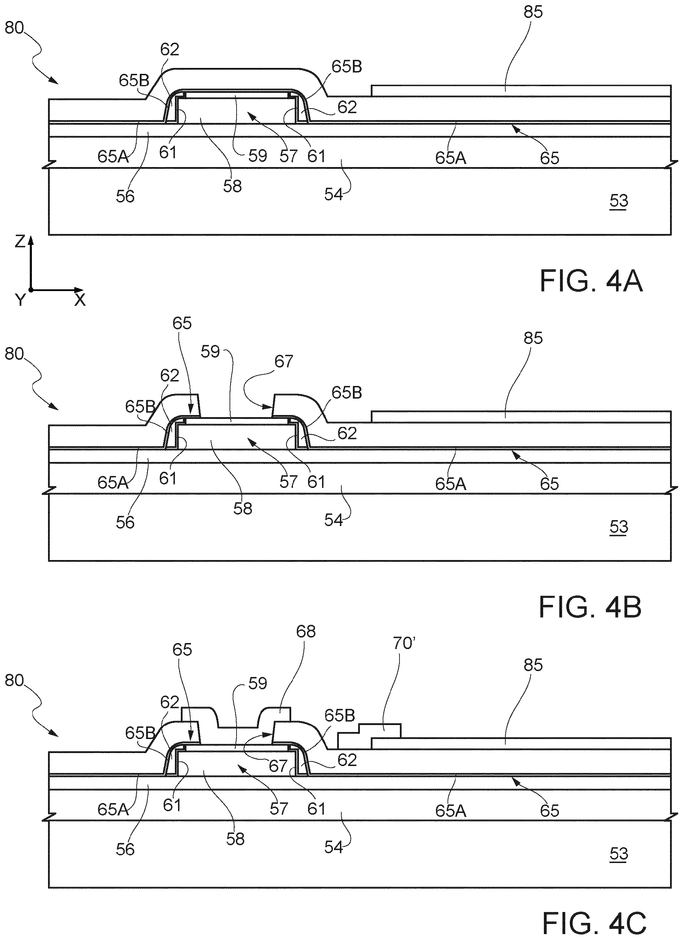

Figures 4A-4C relate to a different embodiment, including a double-level field plate.

In particular, Figure 4A shows wafer 80 after the step of Figure 3F. Here, before opening first insulating layer 66 and passivation layer 65, a step forming region 85 is formed. For example, a SiN layer is deposited and defined. Step forming region 85 extends here laterally to gate region 57, on the side thereof facing drain metal region 73.

In Figure 4B, first insulation layer 66 and passivation layer 65 are etched to form gate opening 67 and to expose the top surface of gate region 57, analogously to what described above with reference to Figure 3G.

In Figure 4C, gate metal layer is deposited and defined to form gate metal 68 (in gate opening 67) and field plate 70'. Here, field plate 70' extends partially over the first insulation layer 66 and partially on the step forming region 85 and thus is not planar.

Then, the second insulating layer 69 is deposited and etched; the source and drain metal region 72, 73 are formed and final manufacturing steps follow, as described above.

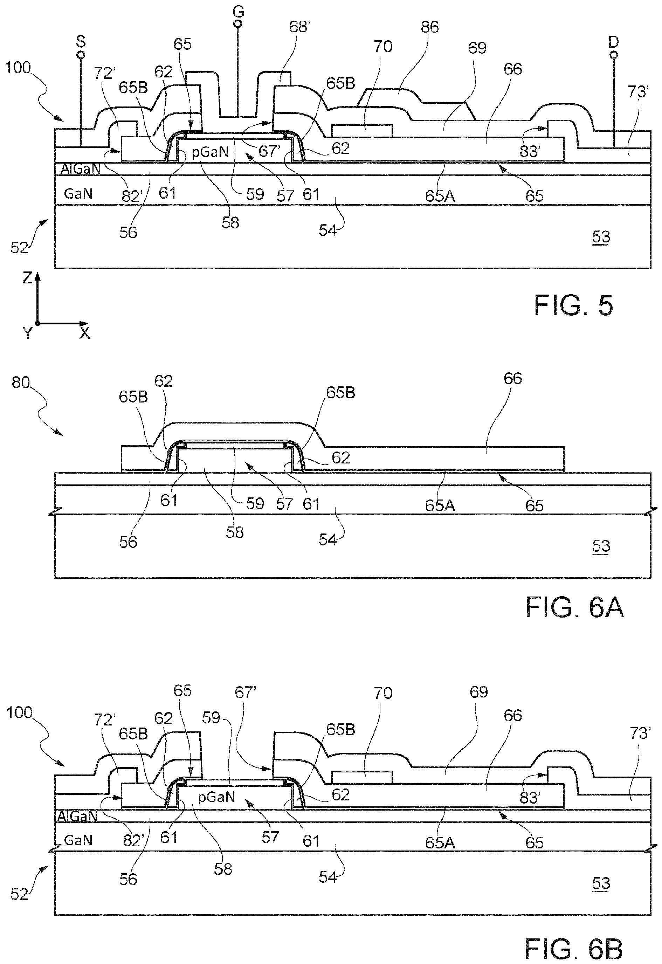

Figure 5 shows an HEMT device 100 wherein the source and the drain metal regions are formed before the gate metal region.

In detail, in Figure 5, where regions common to HEMT device 50 of Figure 2 have been indicated using the same reference numbers, source and the drain metal regions (here indicated by 72', 73') are formed only through the first insulation layer 66 and gate metal region (here indicated by 68') is formed after forming the second insulation layer 69, through both insulation layers 66, 69.

In detail, as shown in Figure 6A, after forming the first insulation layer 66 (Figure 3F), the latter is defined to form source opening, here indicated by 82' and drain opening, here indicated by 83'. Passivation layer 65 is also removed from the body 52, at the source opening 82' and drain opening 83'.

Then, source metal region 72', drain metal region 73' and field plate 70 are formed, by depositing and defining a same metal layer or stack, for example of Ti/AlCu/TiN.

Thereafter, Figure 6B, second insulation layer 69 is deposited and etched (together with first insulation layer 66 and passivation layer 65) to form gate opening, here indicated by 67'. Thus, in Figures 6B and 5, gate opening 67' extends through both the first and the second insulation layers 66, 69.

Gate metal, here indicated by 68', is then formed, by depositing and defining a metal layer or stack, for example Ti/AlCu/TiN; in this step, a shielding region 86 may be formed from the same metal layer of gate metal 68'.

Shielding region 86 may be electrically coupled other regions in the substrate 52 by forming one or more vias through first and second insulation layers 66, 69, in a position not shown in Figure 5.

Then, final manufacturing steps follow, as described above.

Finally, it is clear that numerous variations and modifications may be made to the HEMT device and process described and illustrated herein, all falling within the scope of the invention, as defined in the attached claims.

In general, passivation layer 65 may have same or greater thickness than the sealing regions 61.

Summarizing, example embodiments of the present disclosure are the following.

Example 1. A HEMT device (50; 100) comprising:
a semiconductor body (52) having a semiconductive heterostructure (54, 56);
a gate region (57), comprising a semiconductor material, arranged on the semiconductor body (52), the gate region having lateral sides;
sealing regions (61) of non-conductive material, extending on and in contact with the lateral sides of the gate region (57); and
a passivation layer (65) of non-conductive material, the passivation layer having surface portions (65A) extending on the semiconductor body (52), laterally and at a distance from the lateral sides of the gate region,
the sealing regions (61) and the passivation layer (65) having different geometrical parameters and/or being of different material.

Example 1bis. A HEMT device according to example 1, wherein gate region (57) is arranged in direct contact with the semiconductor body (52).

Example 1ter. A HEMT device according to example 1 or 1bis, wherein the surface portions (65A) of the passivation layer (65) are arranged on and in direct contact with the semiconductor body (52).

Example 2. A HEMT device according to example 1, 1bis or 1ter, further comprising:
an insulating structure (66, 69) extending above the semiconductor body (52), laterally and on top of the gate region;
a first current conducting terminal (72; 72'), of conductive material, extending on and in contact with the semiconductor body (52) laterally to one of the lateral sides of the gate region (57), at least partially through the insulating structure (66, 69);
a second current conducting terminal (73; 73'), of conductive material, extending on and in contact with the semiconductor body (52) laterally to another of the lateral sides of the gate region (57), at least partially through the insulating structure (66, 69); and
a control terminal (68; 68'), of conductive material, extending on and in contact with the gate region (57), at least partially through the insulating structure (66, 69).

Example 3. A HEMT device according to any of the preceding examples, wherein the sealing regions (61) are of an insulating material, such as Al₂O₃, HfO₂, AlN and AlON.

Example 4. A HEMT device according to any of the preceding examples, wherein the sealing regions (61) have a thickness comprised between 2 and 10 nm, for example of 2.5 nm.

Example 5. A HEMT device according to any of the preceding examples, wherein the passivation layer (65) is of an insulating material, such as AlN.

Example 6. A HEMT device according to any of the preceding examples, wherein the passivation layer (65) has a thickness comprised between 2 and 10 nm, for example of 5 nm.

Example 7. A HEMT device according to any of the preceding examples, wherein the passivation layer (65) has a greater thickness than the sealing regions (61).

Example 8. A HEMT device according to any of the preceding examples, further comprising spacer regions (62), of dielectric material, extending laterally and in contact with the sealing regions (61), the passivation layer (65) having raised portions (65B) extending on the spacer regions (62), laterally and at a distance from the sealing regions.

Example 9. A process for manufacturing a HEMT device (50; 100), the process comprising:
on a semiconductor body (52) having a semiconductive heterostructure (54, 56), forming a gate region (57), the gate region including a semiconductor material and arranged on the semiconductor body (52), the gate region having lateral sides;
forming sealing regions (61), of non-conductive material, on and in contact with the lateral sides of the gate region (57); and
forming a passivation layer (65) of non-conductive material, the passivation layer having surface portions (65A) extending on the semiconductor body (52), laterally and at a distance from the lateral sides of the gate region,
the sealing regions (61) and the passivation layer (65) having different geometrical parameters and/or being of different material.

Example 10. A process according to the preceding example, wherein forming sealing regions (61) comprises:
forming, on the gate region (57) and on the semiconductor body (52), a sealing layer (61);
forming, on the sealing layer and adjacent to the gate region, spacer regions (62); and
selectively removing the sealing layer (61) on the semiconductor body (52), where exposed.

Example 10bis. A process according to the preceding example, wherein selectively removing the sealing layer (61) includes removing the sealing layer (61) on top of the gate region (57).

Example 11. A process according to example 10 or 10bis, wherein selectively removing the sealing layer (61) comprises using an etchant selective with respect to the semiconductor body (52).

Example 12. A process according to example 10 or 11, wherein forming a passivation layer (65) comprises:
depositing the passivation layer (65) on the semiconductor body (52), on the spacer regions (62) and on a top surface of the gate region (57); and
selectively removing the passivation layer (65) from the top surface of the gate region.

Example 13. A process according to the preceding example, wherein selectively removing the passivation layer (65) comprises:
forming a first insulating layer (66) on the passivation layer (65);
forming a control opening (67) in the first insulating layer (66), above the gate region (57); and
removing the passivation layer (65) in the control opening (67);
the process further comprising:
   forming a control terminal (68) of conductive material on the gate region, the control terminal extending in the control opening (67);
   forming a second insulating layer (69) on the first insulating layer (66) and on the control terminal (68);
   forming a first conduction opening (82) and a second conduction opening (83) through the first and second insulating layers (66, 69), laterally to the sealing regions (61); and
   forming a first and second current conducting terminal (72, 73) of conductive material on and in contact with the semiconductor body (52) in the first and, respectively, the second conduction openings (82, 83).

Example 14. A process according to example 12, the process further comprising:
forming a first insulating layer (66) on the passivation layer (65);
forming a first conduction opening (82') and a second conduction opening (83') through the first insulating layer (66), laterally to the sealing regions (61);
forming a first and second current conducting terminals (72', 73') of conductive material on and in contact with the semiconductor body (52) in the first and, respectively, the second conduction openings (82', 83');
forming a second insulating layer (69) on the first insulating layer (66) and on the first and second current conducting terminals (72', 73');
forming a control opening (67') through the first and second insulating layers (66, 69), above the gate region (57), wherein forming a control opening (67') comprises said selectively removing the passivation layer (65); and
forming a control terminal (68') of conductive material on the gate region (57), the control terminal extending in the control opening (67').

Example 15. A process according to any of examples 9-14, wherein the sealing regions (61) are of a first insulating material, such as Al₂O₃, HfO₂, AlN and AlON, and the passivation layer (65) is of a second insulating material, such as AlN.

Example 16. A process according to any of examples 9-14, wherein the sealing regions (61) and the passivation layer (65) have different thicknesses.

## Claims

1. A HEMT device (50; 100) comprising:
a semiconductor body (52) having a semiconductive heterostructure (54, 56);
a gate region (57), comprising a semiconductor material, arranged on the semiconductor body (52), the gate region having lateral sides;
sealing regions (61) of non-conductive material, extending on and in contact with the lateral sides of the gate region (57);
a passivation layer (65) of non-conductive material, the passivation layer having surface portions (65A) extending on the semiconductor body (52), laterally and at a distance from the lateral sides of the gate region; and
spacer regions (62), extending laterally and in contact with the sealing regions (61), the passivation layer (65) furthermore having raised portions (65B) extending on the spacer regions (62), laterally and at a distance from the sealing regions (61),
the sealing regions (61) and the passivation layer (65) having different thicknesses and/or being of different material.

2. A HEMT device according to claim 1, further comprising:
an insulating structure (66, 69) extending above the semiconductor body (52), laterally and on top of the gate region;
a first current conducting terminal (72; 72'), of conductive material, extending on and in contact with the semiconductor body (52) laterally to one of the lateral sides of the gate region (57), at least partially through the insulating structure (66, 69);
a second current conducting terminal (73; 73'), of conductive material, extending on and in contact with the semiconductor body (52) laterally to another of the lateral sides of the gate region (57), at least partially through the insulating structure (66, 69); and
a control terminal (68; 68'), of conductive material, extending on and in contact with the gate region (57), at least partially through the insulating structure (66, 69).

3. A HEMT device according to claim 1 or 2, wherein the sealing regions (61) are of an insulating material, such as Al₂O₃, HfO₂, AlN and AlON.

4. A HEMT device according to any of the preceding claims, wherein the sealing regions (61) have a thickness comprised between 2 and 10 nm, for example of 2.5 nm.

5. A HEMT device according to any of the preceding claims, wherein the passivation layer (65) is of an insulating material, such as AlN.

6. A HEMT device according to any of the preceding claims, wherein the passivation layer (65) has a thickness comprised between 2 and 10 nm, for example of 5 nm.

7. A HEMT device according to any of the preceding claims, wherein the passivation layer (65) has a greater thickness than the sealing regions (61).

8. A HEMT device according to any of the preceding claims, wherein the spacer regions (62) are of a dielectric material, such as silicon oxide.

9. A process for manufacturing a HEMT device (50; 100), the process comprising:
on a semiconductor body (52) having a semiconductive heterostructure (54, 56), forming a gate region (57), the gate region including a semiconductor material and arranged on the semiconductor body (52), the gate region having lateral sides;
forming sealing regions (61), of non-conductive material, on and in contact with the lateral sides of the gate region (57);
forming spacer regions (62), laterally and in contact with the sealing regions (61); and
forming a passivation layer (65) of non-conductive material, the passivation layer having surface portions (65A) extending on the semiconductor body (52), laterally and at a distance from the lateral sides of the gate region, the passivation layer (65) furthermore having raised portions (65B) extending on the spacer regions (62), laterally and at a distance from the sealing regions (61),
the sealing regions (61) and the passivation layer (65) having different thicknesses and/or being of different material.

10. A process according to the preceding claim, wherein forming sealing regions (61) comprises:
before forming the spacer regions (62), forming, on the gate region (57) and on the semiconductor body (52), a sealing layer (61); and
after forming the spacer regions (62), selectively removing the sealing layer (61) on the semiconductor body (52), where exposed,
wherein forming the spacer regions (62) comprises forming the spacer regions (62) on the sealing layer and adjacent to the gate region.

11. A process according to the preceding claim, wherein selectively removing the sealing layer (61) comprises using an etchant selective with respect to the semiconductor body (52).

12. A process according to claim 10 or 11, wherein forming a passivation layer (65) comprises:
depositing the passivation layer (65) on the semiconductor body (52), on the spacer regions (62) and on a top surface of the gate region (57); and
selectively removing the passivation layer (65) from the top surface of the gate region.

13. A process according to the preceding claim, wherein selectively removing the passivation layer (65) comprises:
forming a first insulating layer (66) on the passivation layer (65);
forming a control opening (67) in the first insulating layer (66), above the gate region (57); and
removing the passivation layer (65) in the control opening (67) ;
the process further comprising:
forming a control terminal (68) of conductive material on the gate region, the control terminal extending in the control opening (67);
forming a second insulating layer (69) on the first insulating layer (66) and on the control terminal (68);
forming a first conduction opening (82) and a second conduction opening (83) through the first and second insulating layers (66, 69), laterally to the sealing regions (61); and
forming a first and second current conducting terminal (72, 73) of conductive material on and in contact with the semiconductor body (52) in the first and, respectively, the second conduction openings (82, 83).

14. A process according to claim 12, the process further comprising:
forming a first insulating layer (66) on the passivation layer (65);
forming a first conduction opening (82') and a second conduction opening (83') through the first insulating layer (66), laterally to the sealing regions (61);
forming a first and second current conducting terminals (72', 73') of conductive material on and in contact with the semiconductor body (52) in the first and, respectively, the second conduction openings (82', 83');
forming a second insulating layer (69) on the first insulating layer (66) and on the first and second current conducting terminals (72', 73');
forming a control opening (67') through the first and second insulating layers (66, 69), above the gate region (57), wherein forming a control opening (67') comprises said selectively removing the passivation layer (65); and
forming a control terminal (68') of conductive material on the gate region (57), the control terminal extending in the control opening (67').

15. A process according to any of claims 9-14, wherein the sealing regions (61) are of a first insulating material, such as Al₂O₃, HfO₂, AlN and AlON, and the passivation layer (65) is of a second insulating material, such as AlN.
